# EUROPÄISCHE PATENTSCHRIFT

(11) **EP 2 176 570 B1**
(45) Veröffentlichungstag und Bekanntmachung des Hinweises auf die Patenterteilung: **23.09.2015**
(21) Anmeldenummer: 08774314.2
(22) Anmeldetag: 26.06.2008
(51) Int. Cl.: F16H 61/00, H05K 1/02

(54) **VERWENDUNG EINES ELEKTRONISCHEN MODULS FÜR EINE INTEGRIERTE MECHATRONISCHE GETRIEBESTEUERUNG MIT VEREINFACHTEM AUFBAU**
USE OF AN ELECTRONIC MODULE FOR AN INTEGRATED MECATRONIC GEARBOX CONTROLLER OF SIMPLIFIED DESIGN
UTILISATION D'UN MODULE ÉLECTRONIQUE POUR UNE COMMANDE D'ENTRAÎNEMENT MÉCATRONIQUE INTÉGRÉE DE CONCEPTION SIMPLIFIÉE

(30) Priorität: 12.07.2007 DE 102007032535
(43) Veröffentlichungstag der Anmeldung: 21.04.2010
(73) Patentinhaber: Continental Automotive GmbH, 30165 Hannover (DE)
(72) Erfinder: PREUSCHL, Thomas, 93161 Eilsbrunn (DE); LOIBL, Josef, 93077 Bad Abbach (DE); ROBIN, Hermann-Josef, 93053 Regensburg (DE); SMIRRA, Karl, 83512 Wasserburg (DE)
(86) Internationale Anmeldenummer: PCT/EP2008/058126
(87) Internationale Veröffentlichungsnummer: WO 2009/007241

(56) Entgegenhaltungen:
- WO-A-2005/058664
- WO-A-2006/066983
- WO-A1-2009/000594
- DE-A1- 10 130 833
- DE-A1- 19 518 522
- US-B1- 6 705 005

## Beschreibung

Die Erfindung betrifft die Verwendung eines elektronischen Moduls für eine integrierte mechatronische Getriebesteuerung gemäß dem Oberbegriff des Patentanspruchs 1, insbesondere für Getriebe- oder Motorsteuerungen in der Automobilindustrie.

### Stand der Technik

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu integrierten mechatronischen Steuerungen, also zur Integration von Steuerelektronik und den zugehörigen elektronischen Komponenten wie Sensoren oder Ventile in das Getriebe, den Motor oder das Bremssystem. Steuergeräte weisen also im Allgemeinen eine Vielzahl an elektronischen Komponenten auf, welche in Verbindung mit anderen Komponenten außerhalb des Steuergerätes stehen. Bei solchen "Vorort-Elektroniken" sind diese Steuerungen nicht mehr in einem separaten geschützten Elektronikraum untergebracht und müssen daher entsprechenden Umwelteinflüssen und mechanischen, thermischen sowie chemischen Beanspruchungen standhalten.

Sie werden zu diesem Zweck normalerweise in spezielle Gehäuse eingesetzt. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

Der übliche Aufbau für solche integrierten mechatronischen Anwendungen besteht aus einem keramischen Substrat, das die verschiedenen elektronischen Bauteile der zentralen Steuerungseinheit beinhaltet. Dieses keramische Substrat wird mittels Bonden mit starren oder flexiblen Leiterplatten verbunden, um die Anbindung der peripheren Komponenten an die Zentraleinheit zu ermöglichen. Wie schon beschrieben sind zum Beispiel Getriebesteuerungsmodule im Getriebeölsumpf untergebracht und daher vollständig mit Öl und der darin enthaltenen leitenden Kontamination umgeben. Dies können zum Beispiel Kontaminationen aus Verzahnungsabrieb, Zerspanungsreste aus Fertigungsprozessen oder unzugänglichen Wasch- und Reinigungsprozessen des Getriebegehäuses und/oder der verbauten Komponenten sein. Zum notwendigen Schutz vor solcher Kontamination, vor Beschädigungen und Leiterbahn- oder Bondkurzschlüssen wird eine Verdeckelung, üblicherweise als metallischer, nicht-metallischer oder metallisierter Gehäusedeckel, auf die Gehäusebodenplatte aufgebracht und hermetisch abgedichtet. Dieser Gesamtverbund aus keramischem Substrat, Leiterplatten und deren Anbindung zur elektronischen Verbindung der Peripherie sowie hermetisch dichtem Gehäuse ist ein signifikanter Kostentreiber. Gerade die bevorzugt als Schaltungsträger eingesetzten LTCCs (Low Temperature co-fired Ceramics), die zur mechanischen Stabilität und thermischen Anbindung auf eine Grundplatte aufgebracht werden, stellen einen großen Kostenfaktor des gesamten Bauteils dar. Ihre elektronische Verbindung über flexible Leiterplatten oder Stanzgitter zu den außerhalb des abgedichteten Gehäuses liegenden Komponenten ist zudem aufwendig und daher kostenträchtig.

Das Dokument DE 10 130 833 A1 zeigt den nächstliegenden Stand der Technik mit allen Merkmalen des Oberbegriffs von Anspruch 1.

### Aufgabenstellung

Aufgabe der Erfindung ist es daher, eine Verwendung für ein elektronisches Modul mit einem Gehäuse, einer darin untergebrachten zentralen Steuerungseinheit umfassend verschiedene elektronische Bauteile und einer elektronischen Verbindung zwischen dem Gehäuseinnenraum und dem Gehäuseaußenraum anzugeben, welche eine einfache und flexible Verbindung zu außerhalb des Gehäuses liegenden Komponenten ermöglicht, wobei die elektronische Verbindung und die zentrale Steuerungseinheit einen vereinfachten und daher kostengünstigeren Aufbau aufweist und gleichzeitig sicher vor Kurzschluss und/oder leitender Kontamination geschützt ist.

Dies wird erfindungsgemäß durch die Verwendung einer Vorrichtung entsprechend des Patentanspruchs 1 erreicht.

Erfindungsgemäß wird vorgeschlagen, ein elektronisches Modul mit mindestens einem Gehäusedeckel und einer mehrlagigen Leiterplatte als elektrische Verbindung zwischen dem Gehäuseinnenraum und außerhalb des Gehäuses liegenden Komponenten, bei dem die mehrlagige Leiterplatte Schaltungsträger für die elektronischen Bauteile der zentralen Steuerungselektronik und gleichzeitig thermische Anbindung an die Bodenplatte ist, für eine integrierte mechatronische Getriebesteuerung zu verwenden.

Mit anderen Worten wird erfindungsgemäß ein Leiterplattenaufbau als Signal- und Potentialverteilungskomponente für eine integrierte mechatronische Getriebesteuerung eingesetzt, der weiterhin die elektronischen Bauteile der zentralen Steuerungseinheit trägt und zudem die Ableitung der durch die Leistungseinheiten erzeugten Wärme sicherstellt. Der Einsatz teurer keramischer Schaltungsträger wie beispielsweise LTCCs (Low Temperature co-fired Ceramics) oder HTCs (High Temperature Ceramics) und deren Anbindung mittels starrer oder flexibler Leiterplatten an die peripheren Komponenten ist damit nicht mehr notwendig. Durch die erfindungsgemäße Verwendung der elektronischen Module kann vorteilhaft die Trägerwirkung, die Signal- und Potentialverteilung und die thermische Anbindung an die wärmeableitende Bodenplatte oder Halterung von einer einzigen Komponente, nämlich der Leiterplatte, übernommen werden. Die Bodenplatte kann erfindungsgemäß auch die Hydraulikplatte eines Kraftfahrzeuggetriebes sein. Auf diese Weise können signifikante Kosten der keramischen LTCCs und deren aufwendige Anbindung an die Wärmeableitung und die peripheren Komponenten wie Sensoren, Ventile oder andere Aktoren, gegenüber dieser bisher üblichen Form und Verwendung vermieden werden. Es können erfindungsgemäß beispielsweise PCB-Leiterplatten (Printed Circuit Bords) eingesetzt werden.

Um eine verbesserte und definiertere Wärmeableitung zu erzielen kann das erfindungsgemäß verwendete elektronische Modul in einer bevorzugten Weiterbildung auf eine Bodenplatte auflaminiert sein.

Die Bodenplatte besteht in dieser Verwendung bevorzugter Weise aus einem metallischen Material, besonders bevorzugt ist sie aus Aluminium. In einer bevorzugten Ausführungsform der Erfindung wird die mehrlagige Leiterplatte auf die metallische Bodenplatte auflaminiert. Dies stellt eine verlässliche und kostengünstige Fixierung sicher. Zudem wird auf diese Weise eine Abdichtung des Elektronikraums nach unten beispielsweise zum Getriebeöl hin erreicht. Der Gehäusedeckel kann aus jedem Material bestehen, das eine sichere Abdeckung der Oberfläche des Elektronikraums mit den Bauelementen der zentralen Steuerungseinheit erlaubt und gleichzeitig die notwendigen EMV-Abschirmwerte mitbringt. Beispielsweise kann ein metallisierter Kunststoff-Formkörper eingesetzt werden. In einer vorteilhaften Ausgestaltung wird der Gehäusedeckel jedoch ebenfalls aus einem metallischen Material wie beispielsweise Stahlblech gefertigt. Dadurch ergeben sich eine erhöhte Langzeitstabilität und verbesserte Abschirmwerte über die gesamte Lebensdauer der elektronischen Steuervorrichtung. Zudem wird eine verbesserte Diffusionsdichte erzielt.

In einer bevorzugten Ausgestaltung der Erfindung kann die mehrlagige Leiterplatte verschiedene Vias zur thermischen Anbindung an die Bodenplatte und zur elektronischen Anbindung an die außerhalb des Gehäuses liegenden Komponenten aufweisen.

Unter dem Begriff Via (Vertical Interconnection Access) wird erfindungsgemäß eine Durchkontaktierung verstanden, die zwischen den Leiterbahnebenen einer mehrlagigen Leiterplatte angeordnet ist.

Die Verbindung wird meist mit einer innen metallisierten Bohrung im Trägermaterial der Leiterplatte oder Platine hergestellt. Auch Nieten und Stifte sind üblich.

Solche Durchkontaktierungen werden hergestellt, indem das Loch im Trägermaterial bekeimt, das heißt mit einem Katalysator belegt, anschließend katalytisch metallisiert und danach gegebenenfalls elektrolytisch verstärkt wird.

Die Durchkontaktierungs-Bohrung kann gleichzeitig als Lötauge für bedrahtete elektronische Bauelemente dienen oder nur zum Zweck der elektrischen Kontaktierung angebracht sein. Spezielle Vias können auch oder ausschließlich zur Verbesserung der vertikalen Wärmeleitung dienen, dann werden sie auch thermische Vias genannt. Alternativ oder kumulativ können zur Wärmeableitung auch metallische Inlays, bevorzugt Kupfer-Inlays, verwendet werden.

Zur Verringerung der Leitungs-Induktivität oder zur Erhöhung der Stromtragfähigkeit können für eine Verbindung parallel mehrere Durchkontaktierungen eingebracht sein.

Mit Hilfe von Durchkontaktierungen ist es möglich, die Leiterbahnebenen in zwei- oder mehrlagigen Leiterplatten zu wechseln. Dies ist insbesondere hinsichtlich einer guten Entflechtung komplexer Schaltungen von großem Vorteil. Wenn das Loch der Durchkontaktierung einen sehr kleinen Durchmesser hat, nennt man die Durchkontaktierung auch Micro-Via. Diese Micro-Vias können beispielsweise mit einem Laser gebohrt werden.

Ein anderer Typ der gattungsgemäßen Kontaktierung reicht nicht durch die ganze Platine sondern nur bis auf eine der Mittellagen. In diesem Fall wird die Kontaktierung blindes Via genannt. Befinden sich die speziellen Durchkontaktierungen gewissermaßen vergraben nur zwischen Mittellagen, so wird häufig der Ausdruck buried Via eingesetzt.

Bedrahtete elektronische Bauteile werden zunehmend durch unbedrahtete Surface Mounted Devices ersetzt, daher besitzen heutige Leiterplatten eine größere Zahl an Durchkontaktierungen, die kein elektronisches Bauteil aufnehmen. Vorteilhafterweise liefern durchkontaktierte mehrlagige Leiterplatten einen besseren Halt und eine zuverlässigere Verbindung bedrahteter elektronischer Bauteile. Sie sind daher auch bei einfachen Baugruppen hoher Qualität einsetzbar. Zusätzlich kann eine sehr variable Ausgestaltung der Dicke der Leiterbahnlagen in der erfindungsgemäßen Verwendung realisiert werden, was bei herkömmlich eingesetzten flexiblen Leiterplatten nicht möglich ist.

In einer weiteren Ausführungsform kann die mehrlagige Leiterplatte einstückig oder mehrteilig ausgeführt sein.

Alternativ oder kumulativ kann die mehrlagige Leiterplatte mittels Tiefenfräsen flexible Bereiche aufweisen. Dadurch kann die Leiterplatte in der erfindungsgemäßen Verwendung als drei dimensionale Struktur an die speziellen Vorgaben des Trägerelements einer integrierten mechatronischen Getriebesteuerung angepasst werden, ohne dass eine zusätzliche Verbindung zu flexiblen Verbindungskomponenten benötigt wird. Auch komplexe Strukturen sind so realisierbar. Gleichermaßen können mittels spezieller Frästechniken flexible Bereiche im Kontaktstellenbereich angeordnet werden, um eine vereinfachte Verbindung zu peripheren Komponenten bereit zu stellen.

Wie vorstehend angedeutet kann ein Trägerelement aus Kunststoff und/oder Metall in der erfindungsgemäßen Verwendung eines elektronischen Moduls zur Erhöhung der Steifigkeit oder zur Verbesserung der Wärmeabfuhr auch partiell beispielsweise durch Kleben an einen Bereich des elektronischen Moduls befestigt werden.

In einer bevorzugten Ausgestaltung der erfindungsgemäßen Verwendung kann die elektronische Anbindung der außerhalb des Gehäuses liegenden Komponenten mittels Einpresstechnik, Löten und/oder Laserschweißen ausgeführt werden.

Über so genannte Pressfit-Pins in der Einpresstechnik kann eine variable, einfache und sichere elektronische Verbindung zu den peripheren Komponenten hergestellt werden. Gleichermaßen bevorzugt kann diese Verbindung je nach Anforderung der Komponente auch mittels Löten oder Laserschweißen hergestellt werden. Generell ist die Art der Verbindungsherstellung nicht kritisch und kann nach den jeweiligen Voraussetzungen der Komponenten und der vorhandenen Prozesseinrichtungen aus dem Fachmann bekannten Verfahren ausgewählt werden. So können die Verbindungen lösbar beispielsweise als Stecker oder nicht lösbar durch beispielsweise Löten oder Schweißen hergestellt werden. Die Leiterplatte wird besonders bevorzugt direkt mit den Signalgebern und -empfängern (insbesondere Sensoren, Ventile, etc.) außerhalb des Gehäuses verbunden.

In einer anderen bevorzugten Ausgestaltung können die elektronischen Bauteile der zentralen Steuerungselektronik in die mehrlagige Leiterplatte integriert sein. Als elektronische Bauteile können beispielsweise gedruckte Widerstände oder Kapazitäten, die auch als Leitungen oder Flächen ausgeführt sein können, sowie Chips oder komplexe Chips (ICs) eingesetzt werden. Auf diese Weise sind eine erhöhte Langzeitstabilität und eine ausgezeichnete Anbindung an die Signal- und Potentialverteilung gewährleistet.

Die elektronischen Bauteile der zentralen Steuerungselektronik können bevorzugt mittels Lötverfahren, Kleben oder Bonden auf der mehrlagigen Leiterplatte befestigt und/oder kontaktiert sein. Das Lötverfahren kann beispielsweise ein Reflow-Lötverfahren sein.

Alternativ oder zusätzlich können die elektronischen Bauteile der zentralen Steuerungselektronik darüber hinaus mit der mehrlagigen Leiterplatte vergossen sein.

Diese industriellen Verfahren lassen sich leicht automatisieren und damit auch in bereits bestehende Prozesse für die Herstellung von integrierten mechatronischen Getriebesteuerungen eingliedern.

Zur Herstellung eines erfindungsgemäß verwendeten elektronischen Moduls für eine integrierte mechatronische Getriebesteuerung wird mindestens eine mehrlagige Leiterplatte mit den elektronischen Bauteilen der zentralen Steuerungselektronik bestückt. Die Leiterplatte wird auf der Bodenplatte aufgebracht, mit den außerhalb des Gehäuses liegenden Komponenten verbunden und der Gehäusedeckel wird anschließend befestigt. In der Abfolge kann die Bestückung der Leiterplatte entweder vor oder nach dem Aufbringen auf die Bodenplatte erfolgen.

In einer bevorzugten Ausgestaltung der Erfindung wird eine starre mehrlagige Leiterplatte auf einen Gehäuseboden aus Aluminium auflaminiert. Besonders bevorzugt wird die Leiterplatte mittels Acrylkleber auf einer Bodenplatte fixiert. Auf diese Weise können auch Module mit einer Vielzahl von thermisch belastenden Bauteilen mit hoher Langzeitstabilität zur Verfügung gestellt werden.

Die Erfindung wird nachfolgend in beispielhafter Weise anhand von einer Ausführungsvariante in Verbindung mit der Zeichnung erläutert, ohne darauf beschränkt zu sein.

In dieser zeigt:

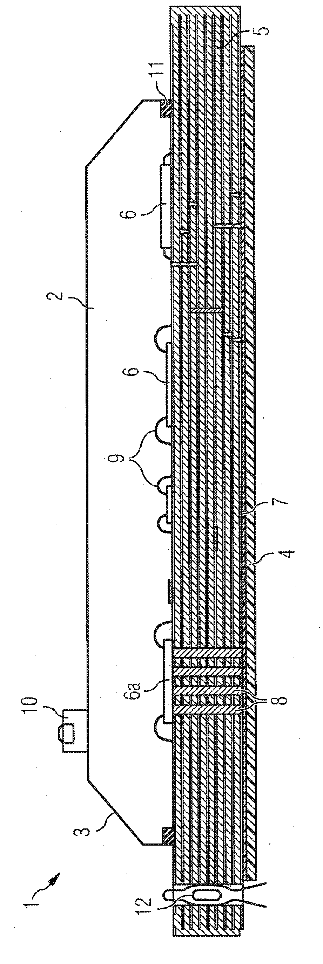

**Fig. 1** eine Schnittdarstellung eines erfindungsgemäß verwendeten elektronischen Moduls für eine integrierte mechatronische Getriebesteuerung.

**Fig. 1** zeigt eine Schnittdarstellung eines Moduls **1** für eine integrierte mechatronische Getriebesteuerung mit einem Gehäuse 2**.** Das Gehäuse **2** wird durch einen Gehäusedeckel **3** und einer Bodenplatte **4** gebildet, auf der eine mehrlagige Leiterplatte **5** als elektrische Verbindung zwischen den im Gehäuseinnenraum und außerhalb des Gehäuses **2** liegenden Komponenten aufgebracht ist. Die mehrlagige Leiterplatte **5** ist erfindungsgemäß zusätzlich Schaltungsträger für verschiedene elektronische Bauteile **6** der zentralen Steuerungselektronik und gleichzeitig thermische Anbindung an die Bodenplatte **4**.

Vorteilhafterweise werden durch die erfindungsgemäße Verwendung mehrere Funktionen durch eine einzige mehrlagige Leiterplatte **5** erfüllt, die vorher von verschiedenen Komponenten übernommen werden mussten.

Die Leiterplatte **5** ist vorzugsweise auf die Bodenplatte **4** auflaminiert. Die Laminierschicht **7** kann eine Wärmeleitkleberschicht sein, die die Wärmeabführung von der zentralen Steuerungselektronik vorteilhaft unterstützt. Die Wärmeableitung von den elektronischen Bauteilen **6**, beispielsweise einem Stromchip **6a**, kann über thermische Vias **8** oder über Kupfer-Inlays realisiert werden, die durch die verschiedenen Schichten der Leiterplatte **5** gebohrt sein können. Die thermischen Vias **8** können mit Wärmeleitpaste gefüllt sein. Die elektrische Anbindung der elektronischen Bauteile **6** auf die Leiterplatte **5** kann beispielsweise durch Dickdrahtbondungen **9** erfolgen. Dies können zum Beispiel Gold-Bonddrähte sein. Die mechanische Befestigung der Bauteile im Elektronikraum, das heißt im Gehäuseinneren kann durch Standard Lötverfahren, beispielsweise Reflow-Lötverfahren, oder durch Kleben erreicht werden. Alternativ oder zusätzlich kann durch eine verschließbare Öffnung **10** im Gehäusedeckel **3** eine Vergussmasse eingefüllt werden, die die mechanische Befestigung und den Schutz der elektronischen Bauteile **6** und der Bonddrähte **9** noch verbessert. Die hermetische Abdichtung des Elektronikraums mit den elektronischen Bauteilen **6** kann auf bekannte Arten, beispielsweise durch Einlegedichtungen **11**, Vergusskleber und/oder Auflaminieren des Gehäusedeckels **3** auf der Bodenplatte **4** und/oder der Leiterplatte **5** realisiert werden. Die elektronische Anbindung von peripheren Komponenten kann zum Beispiel mit einer Pressfit-Verbindung durch Pressfit-Pins **12** oder mittels Laserschweißen erfolgen.

Zusammenfassend wird demnach die Verwendung eines elektronischen Moduls für eine integrierte mechatronische Getriebesteuerung vorgeschlagen, bei dem die Funktion des Schaltungsträgers für die elektronischen Bauteile einerseits und gleichzeitig die elektronische Verbindung zu den peripheren Komponenten durch die Leiterplatte übernommen wird. Die Signal- und Potentialverteilung kann durch die Leiteplatte ebenso zuverlässig und langzeitstabil sichergestellt werden wie die thermische Anbindung an die Bodenplatte oder vergleichbare Wärmeableitungen. Das somit bereitgestellte Modul ist leicht und variabel konfektionierbar und kann mit Standardprozessen gefertigt werden. Insbesondere die Entwicklung neuer Hochtemperatur-Materialien für Leiterplatten (PCBs) und elektronische Bauteile sowie der erfindungsgemäße Einsatz von speziellen Vias zur Ableitung der Wärme ermöglicht eine stark verkleinerte Anordnung der Bauteile im Vergleich zu bisher eingesetzten PCB-Modulen. Die Montage ist daher leicht und kostengünstig in den Gesamtmontageprozess einer elektronischen Vorrichtung integrierbar.

## Patentansprüche

1. Verwendung eines elektronischen Moduls (1) **für eine integrierte mechatronische Getriebesteuerung, wobei das elektronische Modul (1) einen** Gehäusedeckel(3) und mindestens eine starre mehrlagige Leiterplatte (5) als elektrische Verbindung zwischen dem Gehäuseinnenraum und außerhalb des Gehäuses (2) liegenden Komponenten **umfasst**, **und wobei**
die mehrlagige Leiterplatte (5) Schaltungsträger für die elektronischen Bauteile (6) der zentralen Steuerungselektronik und gleichzeitig thermische Anbindung an eine Bodenplatte (4) ist, , **dadurch gekennzeichnet, dass**
die mehrlagige Leiterplatte (5) verschiedene Vias zur elektronischen Anbindung an die außerhalb des Gehäuses (2) liegenden Komponenten **und zur thermischen Anbindung an die Bodenplatte (4) aufweist, wobei die Bodenplatte (4) eine Hydraulikplatte eines Kraftfahrzeuggetriebes ist und weiterhin die mehrlagige Leiterplatte (5) Einfräsungen aufweist, die flexible Bereiche bilden.**

2. Verwendung nach Anspruch 1, **dadurch gekennzeichnet, dass** das erfindungsgemäße Modul (1) auf eine Bodenplatte (4) auflaminiert ist.

3. Verwendung nach einem der Ansprüche 1 oder 2 , **dadurch gekennzeichnet, dass** die mehrlagige Leiterplatte (5) einstückig oder mehrteilig ausgeführt ist.

4. Verwendung nach einem der vorhergehenden Ansprüche, **dadurch gekennzeichnet, dass** die elektronische Anbindung der außerhalb des Gehäuses (2) liegenden Komponenten mittels Einpresstechnik, Löten und/oder Laserschweißen ausgeführt wird.

5. Verwendung nach einem der vorhergehenden Ansprüche, **dadurch gekennzeichnet, dass** die elektronischen Bauteile (6) der zentralen Steuerungselektronik in die mehrlagige Leiterplatte (5) integriert sind.

6. Verwendung nach einem der vorhergehenden Ansprüche, **dadurch gekennzeichnet, dass** die elektronischen Bauteile (6) der zentralen Steuerungselektronik mittels Lötverfahren oder Kleben auf der mehrlagigen Leiterplatte (5) befestigt und/oder kontaktiert sind.

7. Verwendung nach Anspruch 5 , **dadurch gekennzeichnet, dass** die elektronischen Bauteile (6) der zentralen Steuerungselektronik mit der mehrlagigen Leiterplatte (5) vergossen sind.

## Claims

1. Use of an electronic module (1) for an integrated mechatronic gearbox controller, wherein the electronic module (1) comprises a housing cover (3) and at least one rigid, multi-layer printed circuit board (5) as an electrical connection between the interior of the housing and components located outside the housing (2), and wherein the multi-layer printed circuit board (5) is a circuit carrier for the electronic components (6) of the central control electronics and at the same time a thermal connection to a baseplate (4), **characterized in that**
the multi-layer printed circuit board (5) has various vias for connecting electronically to the components located outside the housing (2) and for connecting thermally to the baseplate (4), wherein the baseplate (4) is a hydraulic plate of a motor vehicle gearbox, and the multi-layer printed circuit board (5) also has milled grooves which form flexible regions.

2. Use according to Claim 1, **characterized in that** the module (1) according to the invention is laminated onto a baseplate (4).

3. Use according to one of Claims 1 and 2, **characterized in that** the multi-layer printed circuit board (5) is embodied in one piece or with multiple parts.

4. Use according to one of the preceding claims, **characterized in that** the electronic connection of the components located outside the housing (2) is embodied by means of pressing-in technology, soldering and/or laser welding.

5. Use according to one of the preceding claims, **characterized in that** the electronic components (6) of the central control electronics are integrated into the multi-layer printed circuit board (5).

6. Use according to one of the preceding claims, **characterized in that** the electronic components (6) of the central control electronics are attached to the multi-layer printed circuit board (5) and/or placed in contact therewith by means of soldering methods or bonding.

7. Use according to Claim 5, **characterized in that** the electronic components (6) of the central control electronics are potted with the multi-layer printed circuit board (5).

## Revendications

1. Utilisation d'un module électronique (1) pour un contrôle de transmission mécatronique intégré, le module électronique (1) comprenant un couvercle de boîtier (3) et au moins un circuit imprimé multicouche rigide (5) en tant que liaison électrique entre l'intérieur du boîtier et des composants se trouvant à l'extérieur du boîtier (2) et le circuit imprimé multicouche (5) étant un support de circuit pour les composants électroniques (6) de l'électronique de commande centrale et en même temps une liaison thermique avec une plaque de fond (4), **caractérisée en ce que**
le circuit imprimé multicouche (5) comprend différentes voies pour la liaison électrique aux composants situés à l'extérieur du boîtier (2) et pour la liaison thermique à la plaque de fond (4) ; la plaque de fond (4) étant une plaque hydraulique d'une transmission de véhicule et, en outre, le circuit imprimé multicouche (5) comprenant des fraisages qui forment des zones flexibles.

2. Utilisation selon la revendication 1, **caractérisée en ce que** le module de l'invention (1) est laminé sur une plaque de fond (4).

3. Utilisation selon l'une des revendications 1 ou 2, **caractérisée en ce que** le circuit imprimé multicouche (5) est réalisé de manière monobloc ou en plusieurs parties.

4. Utilisation selon l'une des revendications précédentes, **caractérisée en ce que** la liaison électronique des composants situés à l'extérieur du boîtier (2) est réalisée à l'aide d'un pressage, brasage et/ou soudure au laser.

5. Utilisation selon l'une des revendications précédentes, **caractérisée en ce que** les composants électroniques (6) de l'électronique de commande centrale sont intégrés dans le circuit imprimé multicouche (5).

6. Utilisation selon l'une des revendications précédentes, **caractérisée en ce que** les composants électroniques (6) de l'électronique de commande centrale sont fixés et/ou mis en contact à l'aide d'un procédé de brasage ou de collage sur le circuit imprimé multicouche (5).

7. Utilisation selon la revendication 5, **caractérisée en ce que** les composants électroniques (6) de l'électronique de commande centrale sont moulés avec le circuit imprimé multicouche (5).
